# EUROPÄISCHE PATENTANMELDUNG

(11) **EP 4 394 329 A1**
(43) Veröffentlichungstag der Anmeldung: **03.07.2024**
(21) Anmeldenummer: 22000268.7
(22) Anmeldetag: 31.12.2022
(51) Int. Cl.: G01D 5/14, G01P 3/481, G01R 33/028, G01R 33/00, G01R 33/038, G01R 33/07, G01R 33/09

(54) **VORRICHTUNG ZUR MESSUNG VON MAGNETISCHEN FELDERN**

(71) Anmelder: POLDI microelectronics GmbH, 45657 Recklinghausen (DE)
(72) Erfinder: Grau, Günter, 46282 Dorsten (DE)
(74) Vertreter: Gottschald Patentanwälte Partnerschaft mbB

(57) **Zusammenfassung**

Die Erfindung betrifft eine Vorrichtung zur Messung von magnetischen Feldern mit, insbesondere bestehend aus, mindestens einer sensorischen Komponente und mindestens einer magnetischen Komponente. Es wird vorgeschlagen, dass mindestens eine magnetische Komponente eine hartmagnetische Zone mit magnetischer Hysterese aufweist, mindestens eine sensorische Komponente einen Sensor für magnetische Felder aufweist, die Feldlinien mindestens einer magnetischen Komponente zumindest teilweise eine sensorische Komponente für magnetische Felder durchdringen, die Vorrichtung zur Erfassung diskreter Ereignisse, insbesondere zum Zählen, geeignet ist.

## Beschreibung

Die vorliegende Erfindung betrifft eine Vorrichtung zur Messung von magnetischen Feldern gemäß dem Oberbegriff von Anspruch 1.

Der bekannte Stand der Technik (DE 2143326 A1, DE 2143327 A1), von dem die Erfindung ausgeht, betrifft eine Vorrichtung zur Messung von magnetischen Feldern gemäß dem Oberbegriff von Anspruch 1.

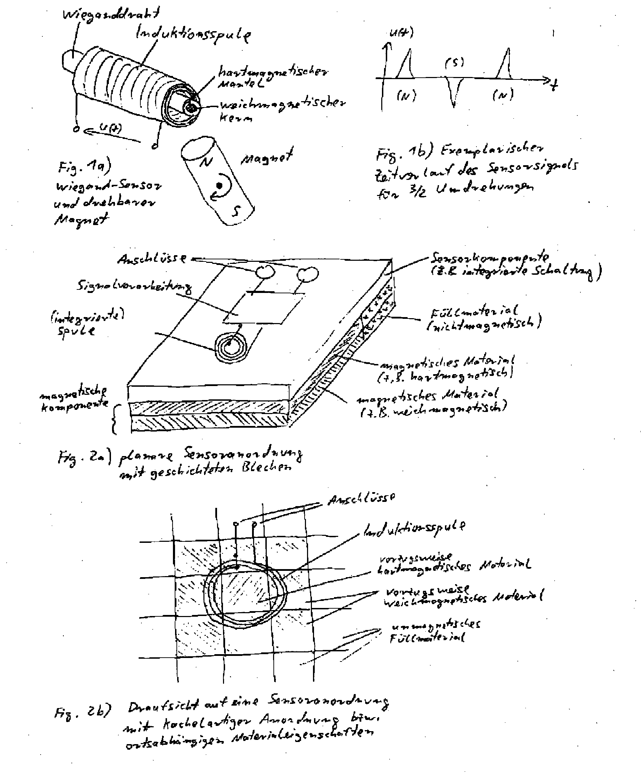

Etwa zum Erfassen von Bewegungen oder zum Zählen von Umdrehungen kommen neben optischen Encodern und magnetischen Sensoren auf Basis von z.B. Halleffekt oder GMR/TMR-Effekt auch sogenannte Wiegand-Sensoren zum Einsatz, die mit einem magnetischen Material mit ausgeprägten Hystereseeigenschaften arbeiten, dem Wiegand-Draht. Ein Wiegand-Draht wird bei der Herstellung zunächst durch Temperung weichmagnetisch und anschließend durch wiederholte Torsion in seiner Struktur so verändert, dass er einen weichmagnetischen Kern und einen hartmagnetischen Mantel aufweist. Einem äußeren Magnetfeld ausgesetzt richtet sich zunächst der weichmagnetische Kern aus, während der hartmagnetische Mantel aufgrund seiner hohen Remanenz seine innere Magnetisierung zunächst beibehält (DE 2143326 A1, DE 2143327 A1). Der Mantel polt seine magnetische Orientierung erst bei Überschreiten einer kritischen Feldstärke um, dann allerdings unabhängig von der Geschwindigkeit der Änderung des äußeren Magnetfeldes praktisch schlagartig. Durch eine um den Wiegand-Draht angeordnete Induktionsspule entsteht so ein steilflankiges Signal mit signifikanter Amplitude (bis zu einigen Volt für handelsübliche Sensoren). Mithilfe des Wiegand-Drahtes kann daher auch eine sehr langsame Bewegung sehr einfach erfasst werden. Mitunter sind die erzeugten Signale so stark, dass sie auch zur Energieversorgung der Schaltung (energy harvesting) herangezogen werden können, da für die starken Signale keine aufwendigen Verstärker benötigt werden und die Energie zum Betrieb eines Zählers mit nichtflüchtigem Speicher ausreicht. So kann etwa die Drehung eines Magneten in der Nähe des Sensors anhand der Zählung von Impulsen erfasst werden, wobei jede Annäherung alternierender magnetischer Pole einen Impuls erzeugt (Fig. 1). Das Vorzeichen der Impulse hängt dabei von der Richtung der Ummagnetisierung des hartmagnetischen Kerns ab.

Eine Herausforderung beim Wiegand-Sensor ist unter anderem der komplizierte Herstellungsprozess des Wiegand-Drahtes. Der Prozess erfordert spezielle Parameter in Bezug auf Material, Durchmesser und Behandlung. Darüber hinaus verwendet der Wiegand-Sensor eine um den Wigand-Draht umlaufende schlanke Induktionsspule, um möglichst viel der freiwerdenden Energie in ein elektrisches Signal umwandeln zu können. Diese Spule ist im Prinzip wie eine Relaisspule gebaut. Der gesamte Sensor bestehend aus Wiegand-Draht und Induktionsspule wird typischerweise vergossen und mit Anschlussbeinen versehen. Er ist also ein sogenanntes diskretes bzw. häufig ein bedrahtetes Bauelement mit Dimensionen in der Größenordnung von 5x5x15 mm und damit wesentlich größer und schwerer als viele Halbleitersensoren.

Einige magnetische Sensoren verwenden Feldplatten, um die Richtung eines Magnetfeldes in der Nähe des Sensors zu beeinflussen oder eine passive Verstärkung zu realisieren. Ein Beispiel hierfür sind 3D-Hallsensoren mit integriertem Feldkonzentrator, wie er z.B. von C. Schott, R. Racz, S. Huber: CMOS Three Axis Hall Sensor and Joystick Application, Proceedings IEEE Sensors Conference 2004, Wien, Österreich, 25.-27.10.2004 beschrieben wurde. In diesem Fall werden allerdings weichmagnetische Werkstoffe verwendet, die möglichst keine Hysterese aufweisen, damit ein akkurates Signal des momentan anliegenden Magnetfeldes gemessen werden kann.

Es ist dabei eine Herausforderung, den bekannten Stand der Technik zu verbessern.

Der Erfindung liegt das Problem zugrunde, die bekannte Vorrichtung zur Messung von magnetischen Feldern derart auszugestalten und weiterzubilden, dass hinsichtlich der genannten Herausforderung eine weitere Optimierung erreicht wird.

Das obige Problem wird durch die Merkmale des kennzeichnenden Teils von Anspruch 1 gelöst.

Wesentlich ist die grundsätzliche Überlegung, einen dem Wiegand-Sensor vergleichbaren Sensor zu realisieren, der planar gebaut und integrierbar ist. Insbesondere ist die Herstellung des Sensors möglichst kompatibel zu Herstellungsschritten von Halbleitern bzw. passt zu typischen Gehäusen für Halbleitern und kann in großen Stückzahlen automatisiert gefertigt werden. Der fertige Sensor kann leicht mit automatischen Bestückern (pick & place) verarbeitet werden.

Im Einzelnen wird vorgeschlagen, dass
- mindestens eine magnetische Komponente eine hartmagnetische Zone mit magnetischer Hysterese aufweist,
- mindestens eine sensorische Komponente einen Sensor für magnetische Felder aufweist,
- die Feldlinien mindestens einer magnetischen Komponente zumindest teilweise eine sensorische Komponente für magnetische Felder durchdringen
- die Vorrichtung zur Erfassung diskreter Ereignisse, insbesondere zum Zählen, geeignet ist.

Im Folgenden wird die Erfindung anhand einer lediglich Ausführungsbeispiele darstellenden Zeichnung näher erläutert.

Das in den Figuren dargestellte und insoweit bevorzugte Ausführungsbeispiel betrifft eine Vorrichtung zur Messung von magnetischen Feldern mit, insbesondere bestehend aus, mindestens einer sensorischen Komponente und mindestens einer magnetischen Komponente.

Wesentlich ist nun, dass
- mindestens eine magnetische Komponente eine hartmagnetische Zone mit magnetischer Hysterese aufweist,
- mindestens eine sensorische Komponente einen Sensor für magnetische Felder aufweist,
- die Feldlinien mindestens einer magnetischen Komponente zumindest teilweise eine sensorische Komponente für magnetische Felder durchdringen
- die Vorrichtung zur Erfassung diskreter Ereignisse, insbesondere zum Zählen, geeignet ist.

Weiter ist hier und vorzugsweise vorgesehen, dass die sensorische und magnetische Komponente planar angeordnet und zu einer Baugruppe vereint sind.

Weiter ist hier und vorzugsweise vorgesehen, dass die magnetische Komponente mindestens einen Schichtstapel mit unterschiedlicher magnetischer Härte aufweist.

Weiter ist hier und vorzugsweise vorgesehen, dass die magnetische Komponente mindestens eine laterale Anordnung von Zonen unterschiedlicher magnetischer Härte aufweist.

Weiter ist hier und vorzugsweise vorgesehen, dass eine Mehrzahl von magnetisch harten Zonen und eine Mehrzahl von Sensoren für Magnetfelder derart angeordnet sind, dass sie eine planare Anordnung mit einer Mehrzahl von Vorrichtungen zur Messung von magnetischen Feldern nach Anspruch 1 bilden.

Weiter ist hier und vorzugsweise vorgesehen, dass die sensorische Komponente eine integrierte Schaltung ist
- mit mindestens einer elektronischen Schaltung
- mit mindestens einem weiteren Sensor
- mit einem optionalen nichtflüchtigen Speicher.

Weiter ist hier und vorzugsweise vorgesehen, dass der mindestens eine weitere Sensor ein Polarisationssensor ist.

Vorschlagsgemäß ist es möglich, einen dem Wiegand-Sensor vergleichbaren Sensor zu realisieren, der planar gebaut und integrierbar ist. Insbesondere ist die Herstellung des Sensors möglichst kompatibel zu Herstellungsschritten von Halbleitern bzw. passt zu typischen Gehäusen für Halbleitern und kann in großen Stückzahlen automatisiert gefertigt werden. Der fertige Sensor kann leicht mit automatischen Bestückern (pick & place) verarbeitet werden.

Vorschlagsgemäß sind dazu zwei Komponenten erforderlich, eine magnetische Komponente mit besonderen Hystereseeigenschaften, insbesondere mit mindestens einer hartmagnetischen Zone, sowie eine sensorische Komponente, die in unmittelbarer Nähe konzentrisch zur magnetischen Komponente zu einer baulichen Einheit angeordnet sind (Fig. 2alb).

Obwohl eine monolithisch integrierte Lösung besonders vorteilhaft wäre, ist die Realisierung der magnetischen Komponente mit den Prozessschritten zur Herstellung einer integrierten Schaltung schwierig. Es wird eine vergleichsweise große Menge Material benötigt, um ausreichend Energie zu speichern, die von der sensorischen Komponente detektiert werden kann. Anstelle von Sputtering (Schichtdicken im um-Bereich) ist daher die Verwendung von Blechen vorteilhaft, um Schichtdicken von einigen 10 bis einigen 100 um verwenden zu können.

Für die magnetische Komponente kommen vorschlagsgemäß in einer ersten Variante geschichtete Bleche unterschiedlicher magnetischer Härte zum Einsatz (Fig. 2a). Die weichmagnetischen Bleche (eins oder mehrere) dienen dabei als Feldkonzentrator, während die hartmagnetischen Bleche (mindestens eines) den Energiespeicher bereitstellen. Dieser wird durch das äußere Magnetfeld hinreichender Stärke ummagnetisiert und erzeugt im Umklapp-Moment ein steilflankiges Signal für die Sensorkomponente. Unter bestimmten Umständen kann auf die weichmagnetische Komponente verzichtet werden, wenn das hartmagnetische Material bereits eine weitgehend rechteckige Hysteresekurve mit hoher Remanenz und ausgeprägter Fläche der Hysteresekurve aufweist. Um Streuverluste zu reduzieren, sollte das hartmagnetische Blech der Sensorkomponente am nächsten sein.

In einer zweiten Ausgestaltung kommen verschachtelt angeordnete Blechstücke unterschiedlicher magnetischer Härte zum Einsatz, die zur einfacheren Handhabung auch als "Kachel" verarbeitet werden können (Fig. 2b). Sie imitieren gewissermaßen die konzentrische Anordnung des Wiegand-Drahtes, können aber durch unterschiedliche Bearbeitungsschritte oder Materialien unabhängig voneinander optimiert werden. Diese Blechstücke können z.B. durch Stanzen oder Laserschneiden hergestellt werden, wobei für eine zweckmäßige Anordnung neben rechteckigen Formen insbesondere wabenförmige Elemente sinnvoll sind. Da die Bearbeitung (z.B. Stanzen, Laserschneiden) die magnetischen Eigenschaften verändern kann, ist es zweckmäßig, zumindest die weichmagnetischen Elemente einer Nachbehandlung zu unterziehen, etwa einer Temperung zur gleichmäßigen Enthärtung. Diese kann vorteilhaft in einem äußeren Magnetfeld stattfinden, um die magnetischen Domänen des Materials auszurichten (bevorzugt senkrecht zur Oberfläche). Da eine nachträgliche Härtung der kleinen Elemente schwierig umzusetzen ist, können vorteilhaft unterschiedliche Materialien zum Einsatz kommen. So eignet sich z.B. gestreckte Nickelfolie mit ihrer ausgeprägten Remanenz gut für hartmagnetische Elemente, während sich z.B. getempertes Mumetall-Blech für weichmagnetische Elemente eignet.

In einer weiteren Ausgestaltung wird nur ein einzelnes Blech verwendet, das durch selektive Behandlung ortsabhängig in seinen magnetischen Eigenschaften verändert wird. So kann ein zuvor (etwa durch mechanische Bearbeitung) gehärtetes Blech durch lokale Wärmebehandlung (etwa selektive Temperung durch Laserbestrahlung) selektiv enthärtet werden. Verschiedene Varianten der Behandlung sind möglich, etwa auch eine selektive Härtung durch lonenimplantation. Die Laserbehandlung erscheint allerdings besonders einfach und effizient umsetzbar. Da die lokale Materialbearbeitung bei dünneren Blechen einfacher ist, können größere Dicken wiederum durch einen Schichtstapel von gleichartig bearbeiteten Blechen realisiert werden.

Die räumliche Ausdehnung der magnetischen Komponente stimmt nicht unbedingt mit derjenigen des Sensors überein. Insbesondere bei einem deutlich größeren Sensorelement (z.B. integrierte Schaltung mit zahlreichen zusätzlichen Funktionen) kann es daher von Vorteil sein, das Blech mit einem nichtmagnetischen Material zu umgeben, um eine ebene Fläche zu erzeugen. Dazu können sowohl metallische (etwa Aluminium) als auch nichtmetallische Werkstoffe (etwa Kunststoff) verwendet werden.

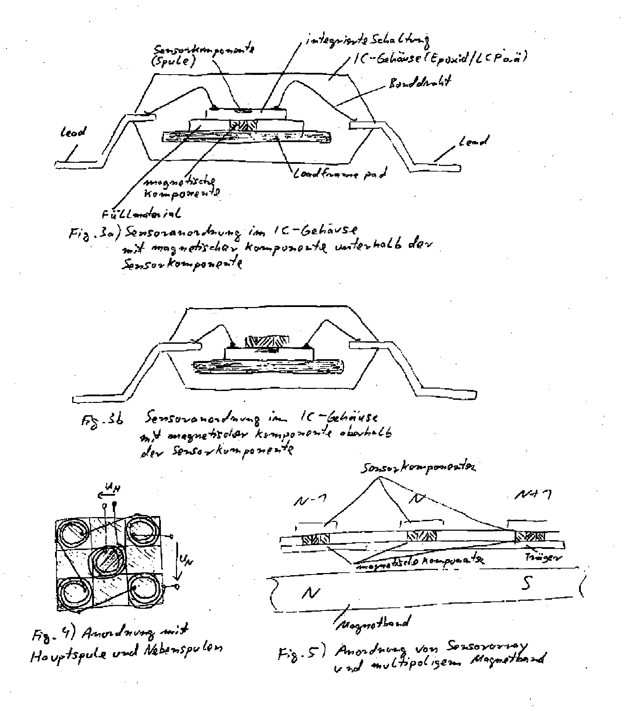

Die magnetische Komponente kann in einer Ausgestaltung in einem noch leeren Chipgehäuse befestigt (etwa geklebt) werden, bevor die Sensorkomponente (etwa eine integrierte Schaltung oder eine Platine) darauf befestigt wird (Fig. 3a). In einer anderen Ausgestaltung kann das Gehäuse eine geeignete Mulde für die magnetische Komponente aufweisen, so dass auf nichtmagnetische Rahmenelemente zur Erzeugung einer ebenen Montagefläche für die Sensorkomponente verzichtet werden kann. Es ist zudem vorstellbar, dass das TrägerBlech eines IC-Gehäuses (Leadframe) selbst als magnetische Komponente des Sensors verwendet werden kann.

Alternativ kann die magnetische Komponente direkt auf der Rückseite der Sensorkomponente befestigt werden, bevor diese dann als Einheit weiter verarbeitet oder verwendet wird, oder die magnetische Komponente wird auf der Vorderseite der Sensorkomponente (z.B. auf der Passivierung einer integrierten Schaltung) befestigt (Fig. 3b). Diese Schritte ließen sich etwa noch vor Vereinzelung der Chips aus einem Wafer oder Platinen aus einem Nutzen realisieren. Die Vorderseite der Sensorkomponente hat insbesondere bei mikroelektronischen Schaltungen den Vorteil, dass z.B. eine integrierte Spule näher am magnetischen Material ist und daher weniger Streuverluste auftreten. Diese Variante bietet sich insbesondere dann an, wenn die magnetische Komponente deutlich kleiner ist als die sensorische Komponente. Auch die Strukturierung und Anordnung der magnetischen Komponente kann dabei wafer-artig erfolgen, so dass nach Vereinzelung mit z.B. Laserschneiden die Übertragung der magnetischen Komponenten auf die sensorische Komponente schnell und preiswert z.B. per Mikro-Transfer-Printing (uTP) erfolgen kann. Auch der umgekehrte Weg des uTP ist bei einer kleinen Sensorkomponente möglich.

Bei einer Anordnung der magnetischen Komponente auf der Rückseite der Sensorkomponente sollte letztere möglichst dünn sein, eine integrierte Schaltung also abgedünnt werden. Dies ist auch vorteilhaft, um die Dicke der gesamten Anordnung zu reduzieren, so dass z.B. ein IC-Package nicht überdurchschnittlich dick wird.

Eine weitere Ausgestaltung verwendet zwei magnetische Komponenten pro Sensorkomponente, eine auf der Oberseite und eine auf der Unterseite. Im weitesten Sinne befindet sich die Sensorkomponente dann im Spalt eines sehr kurzen I-Kerns, Dadurch kann bei hinreichend dünner Sensorkomponente ein stärkerer Fluss durch den Sensor erzeugt werden. Es ist nicht notwendig, aber möglich, dass eine hartmagnetische Komponente auf beiden Seiten der Sensorkomponente existiert.

Die Sensorkomponente kann grundsätzlich mit allen möglichen Sensoren für magnetische Felder arbeiten, also z.B. auch mit Hallsensoren oder GMRIAMR-Sensoren. Zur stromsparenden Detektion und insbesondere auch zum energy harvesting bietet sich allerdings ein passiver Sensor in Form einer Induktionsspule an. Im Falle einer integrierten Schaltung kann diese als integrierte Spule in der Metallisierung der integrierten Schaltung realisiert werden, wobei im Gegensatz zu HF-Spulen die Güte eine untergeordnete Rolle spielt. Stattdessen sollte die Spulengeometrie dahingehend optimiert werden, dass der maximale Fluss aus der spontanen Ummagnetisierung aufgenommen werden kann, so dass eine möglichst hohe Spannung erzeugt wird. Dazu können insbesondere auf den unteren dünnen Metallisierungslagen einer integrierten Schaltung zahlreiche Windungen auf kleinem Raum realisiert werden. Es sind aber auch Spulen z.B. in feinstrukturierten Leiterplatten denkbar.

Da die Sensorkomponente im Gegensatz zum Wiegand-Sensor nun neben der magnetischen Komponente liegt (statt diese zu umfassen), ist die Vermeidung von Streuverlusten schwieriger. Insbesondere wird eine zu groß dimensionierte Spule weniger Signal aufnehmen als eine kleine, da Feldlinien sowohl vom zentralen Haupt- als auch dem peripheren Streufeld die Spulenfläche kreuzen und sich die Signale damit teilweise aufheben. Im Gegensatz zum Wiegand-Draht, der herstellungsbedingt einen hartmagnetischen Mantel aufweist, ist hier ein hartmagnetisches Zentrum von Vorteil, dass von einem weichmagnetischen Konzentrator umgeben sein kann, da das Sensorsignal von der spontanen Ummagnetisierung eines hartmagnetischen Materials ausgeht.

Die Möglichkeiten der Integration erlauben es, neben der zentral angeordneten Spule für das Feld der hartmagnetischen Komponente (Hauptspule) auch Spulen in der Peripherie anzuordnen. Diese nehmen je nach Lage und Ausgestaltung vorwiegend Streufelder oder auch externe Felder wahr (Fig, 4). Damit erhält man ein differentielles Signal, wodurch sich unterscheiden lässt, ob die hartmagnetische Komponente ummagnetisiert wurde oder ein anderes Ereignis aufgetreten ist. Die Störsicherheit des Sensors kann so verbessert werden.

Insbesondere durch Verwendung lokaler Materialbearbeitung (etwa Laserbehandlung) bei der magnetischen Komponente und durch die filigranen Fertigungsmöglichkeiten für integrierte Schaltungen oder auch feinstrukturierter Leiterplatten bei der Sensorkomponente ergeben sich weitere Vorteile aus der hier vorgeschlagenen planaren Anordnung. Es können sehr einfach Anordnungen von mehreren Sensoren in einer Dimension (Kette) oder zwei Dimensionen (Array) realisiert werden, sofern die hartmagnetischen Zonen hinreichend weit voneinander entfernt sind, so dass sie sich nicht gegenseitig stören (Fig. 5). Dies kann ausgenutzt werden, um eine Redundanz zu erzeugen (mehrere unabhängige Sensoren liefern fast zeitgleich ein Signal) oder (etwa durch Serienschaltung mehrerer benachbarter Sensorsignale) ein stärkeres oder zeitlich gestrecktes Signal zu erzeugen.

Es kann aber gerade auch durch Ausnutzung der geringen Zeitunterschiede in der Reaktion benachbarter hartmagnetischer Zonen die Bewegungsrichtung des äußeren Magnetfeldes und damit etwa die Drehrichtung einer Welle erfasst werden. Im Falle von diskreten Wiegand-Sensoren würde dies eine signifikante Baugröße und somit eine deutlich stärkere mechanische Bewegung erfordern als bei der vorliegenden Erfindung. Eine Anordnung von mehreren Sensoren kann auch zur einfacheren Detektion kleinerer Bewegungen verwendet werden, sofern sich noch nicht alle einzelnen Elemente dem äußeren Magnetfeld angepasst haben oder die Polpaar-Abstände des Magneten in der Größenordnung der Ausdehnung des Sensorfeldes liegt. Kombiniert man ein Polrad (vom rotierenden Stabmagneten bis zum Multipol-Magnetband sind verschiedenste Ausführungen verwendbar) mit einer umlaufenden Anordnung von mehrkanaligen Sensoren, so kann man einen passiven magnetischen Winkel-Encoder realisieren.

In diesem Fall bietet es sich an, den Sensor als streifenförmige und flexible Anordnung zu realisieren, die konzentrisch um ein Polrad gelegt werden kann. Dazu ist es vorteilhaft, wenn auch die Sensorkomponente flexibel gestaltet ist (z.B. integrierte Spulen auf einer flexiblen Leiterplatte, die mit einem Blechstreifen verbunden ist, ggfs. mit integrierten Schaltungen, die auf einer flexiblen Leiterbahn befestigt sind). Dies bietet sich insbesondere bei großen Durchmessern der magnetischen Komponente an. Bei kleineren Durchmessern ist hingegen eine planare ringförmige Anordnung vorteilhafter.

Auch passive Linear-Encoder (Positionssensoren) sind so realisierbar. Da die Auflösung basierend auf diesem Effekt begrenzt ist, kann eine Kombination mit aktiven Sensoren verwendet werden, um eine genauere Positions- oder Winkelbestimmung zwischen den magnetischen Impulsen zu realisieren. Es ist denkbar, dass auf diese Weise z.B. ein batterieloser Messschieber oder Encoder realisiert werden kann, da die magnetischen Impulse in deutlich größerer Zahl bzw. höherer Frequenz erzeugt werden können als mit diskreten Wiegand-Sensoren.

Dadurch, dass der hier vorgeschlagene planare Sensor erheblich kleiner ausfällt und auch mit einer integrierten Spule arbeiten kann, ergibt sich die Möglichkeit zu single-chip Sensoren, die neben der Zählfunktion und möglicher Richtungsdetektion auch präzise Winkel- oder Positionsbestimmung ermöglichen. So sind einerseits Kombinationen von dem hier vorgestellten Sensor mit aktiven magnetischen Sensoren (Hall, GMRITMR etc.) möglich, wobei der aktive Sensor sowohl im Bereich der magnetischen Komponente die momentane Feldstärke messen kann, vorzugsweise aber etwas abseits der magnetischen Komponente das unverfälschte externe Magnetfeld in Stärke und Richtung messen kann, um etwa eine genauere Positionsbestimmung auf einem magnetischen Multipol-Band oder -Rad zu ermöglichen. Allerdings kann auch eine Kombination mit anderen Sensortechnologien erfolgen. Insbesondere dann, wenn sich die magnetische Komponente sich auf der Rückseite der Sensorkomponente befindet, die vorzugsweise als integrierte Schaltung ausgeführt ist, kann die Vorderseite der Sensorkomponente auch für optische Sensoren verwendet werden. Besonders vorteilhaft ist hierbei die Kombination des hier vorgestellten magnetischen Sensors mit einem Polarisationssensor (DE 102005031966 A1, EP 1902334 A1), der eine akkurate Drehwinkelbestimmung mit geringem Aufwand ermöglicht. In dieser Kombination ist ein single-Chip-Sensor für Multi-turn-Drehgeber realisierbar, der kaum Justage bedarf, eine hohe Genauigkeit aufweist, und idealerweise die Zählung von magnetischen Impulsen auch ohne äußere Stromzufuhr bewerkstelligt (durch energy harvesting und nichtflüchtige Speicher). Sofern die magnetische Komponente sich unterhalb der Sensorkomponente befindet, kann der optische Sensor sich direkt oberhalb dieser befinden und die magnetische Sensorkomponente den optischen Sensor auch umfassen, ebenso wie auch elektronische Schaltungen im Zentrum der Spule angeordnet sein können. Der optische Sensor kann sich auch neben der magnetischen Sensorkomponente befinden. In diesem Fall gibt es keine Einschränkung in der Ausgestaltung der magnetischen Komponente.

## Patentansprüche

1. Vorrichtung zur Messung von magnetischen Feldern mit, insbesondere bestehend aus, mindestens einer sensorischen Komponente und mindestens einer magnetischen Komponente,
**dadurch gekennzeichnet, dass**
- mindestens eine magnetische Komponente eine hartmagnetische Zone mit magnetischer Hysterese aufweist,
- mindestens eine sensorische Komponente einen Sensor für magnetische Felder aufweist,
- die Feldlinien mindestens einer magnetischen Komponente zumindest teilweise eine sensorische Komponente für magnetische Felder durchdringen
- die Vorrichtung zur Erfassung diskreter Ereignisse, insbesondere zum Zählen, geeignet ist.

2. Vorrichtung zur Messung von magnetischen Feldern nach Anspruch 1, **dadurch gekennzeichnet, dass** die sensorische und magnetische Komponente planar angeordnet und zu einer Baugruppe vereint sind.

3. Vorrichtung zur Messung von magnetischen Feldern nach Anspruch 1 oder 2, **dadurch gekennzeichnet, dass** die magnetische Komponente mindestens einen Schichtstapel mit unterschiedlicher magnetischer Härte aufweist.

4. Vorrichtung zur Messung von magnetischen Feldern nach Anspruch 1 oder 2, **dadurch gekennzeichnet, dass** die magnetische Komponente mindestens eine laterale Anordnung von Zonen unterschiedlicher magnetischer Härte aufweist.

5. Vorrichtung zur Messung von magnetischen Feldern nach einem der vorhergehenden Ansprüche, **dadurch gekennzeichnet, dass** eine Mehrzahl von magnetisch harten Zonen und eine Mehrzahl von Sensoren für Magnetfelder derart angeordnet sind, dass sie eine planare Anordnung mit einer Mehrzahl von Vorrichtungen zur Messung von magnetischen Feldern nach Anspruch 1 bilden.

6. Vorrichtung zur Messung von magnetischen Feldern nach einem der vorhergehenden Ansprüche, **dadurch gekennzeichnet, dass** die sensorische Komponente eine integrierte Schaltung ist
- mit mindestens einer elektronischen Schaltung
- mit mindestens einem weiteren Sensor
- mit einem optionalen nichtflüchtigen Speicher.

7. Vorrichtung zur Messung von magnetischen Feldern nach Anspruch 6, **dadurch gekennzeichnet, dass** der mindestens eine weitere Sensor ein Polarisationssensor ist.
